# EUROPÄISCHE PATENTSCHRIFT

(11) **EP 1 115 004 B1**
(45) Veröffentlichungstag und Bekanntmachung des Hinweises auf die Patenterteilung: **05.04.2006**
(21) Anmeldenummer: 00204208.3
(22) Anmeldetag: 27.11.2000
(51) Int. Cl.: G01R 33/28

(54) **MR-Anordnung zur Lokalisierung und/oder Visualisierung eines mit einer passiven Magnetvorrichtung ausgestatteten Katheters**
MR-device for localising and/or visualising a catheter provided with a passive magnet arrangement
Agencement de RM pour la localisation et/ou la visualisation d'un cathéter muni d'un dispositif à aimant passif

(30) Priorität: 02.12.1999 DE 19958408
(43) Veröffentlichungstag der Anmeldung: 11.07.2001
(73) Patentinhaber: Philips Intellectual Property & Standards GmbH, 20099 Hamburg (DE); Koninklijke Philips Electronics, N.V., 5621 BA Eindhoven (NL)
(72) Erfinder: Schäffter, Tobias, Dr., 52064 Aachen (DE); Weiss, Steffen, 52064 Aachen (DE)
(74) Vertreter: Volmer, Georg

(56) Entgegenhaltungen:
- WO-A-98/55016
- WO-A-99/18852
- US-A- 5 938 601
- DEBATIN J.F., ADAM G.: "Interventional Magnetic Resonance Imaging" 1998 , SPRINGER , BERLIN XP002240199 * Seite 51- Seite 55: H.F.M.Smits and C.J.G. Bakker, "Susceptibility-Based Catheter Visualization"; Seite 57 - Seite 63: A. Glowinski, "Field Inhomogeneity-Based Catheter Visualization" *
- PATENT ABSTRACTS OF JAPAN vol. 013, no. 084 (C-572), 27. Februar 1989 (1989-02-27) & JP 63 270039 A (OLYMPUS OPTICAL CO LTD), 8. November 1988 (1988-11-08)
- GERTHSEN; KNESER; VOGEL: 'PHYSIK, Ein Lehrbuch zum Gebrauch neben Vorlesungen', 1982, SPRINGER, BERLIN * Seite 343 *

## Beschreibung

Die Erfindung betrifft eine MR-Anordnung mit Mitteln zur Lokalisierung und/oder Visualisierung eines in ein Untersuchungsobjekt einführbaren Katheters.

Eine solche Anordnung ist aus der EP 928 972 A2 bekannt. Dort ist eine Mikrospule an einem in das Untersuchungsobjekt, beispielsweise in den Körper eines Patienten, eingeführten medizinischen Instrument, beispielsweise an einem Katheter, befestigt. Die Mikrospule ist dabei frei von Anschlußleitungen und auf die MR-Frequenz der MR-Anordnung abgestimmt. Bei einem Hochfrequenzimpuls ergibt sich im Nahbereich der Mikrospule eine lokale Erhöhung des Magnetfeldes, wodurch die Kemmagnetisierung im Bereich der Mikrospule in anderem Maße beeinflußt wird als im übrigen Untersuchungsbereich, was in einem MR-Bild sichtbar gemacht werden kann und woraus sich die Position der Mikrospule und damit auch des medizinischen Instruments bestimmt werden kann.

Die bekannte Anordnung hat sich jedoch insoweit als nachteilig erwiesen, als in die medizinischen Instrumente eine Mikrospule mit einem Schwingkreis integriert werden muß, die diese Instrumente verteuern, da sie meist nur einmal benutzt werden. Außerdem ist die durch die Mikrospule bewirkte Feldüberhöhung oftmals nicht ausreichend stark, um eine genaue Positionsbestimmung des medizinischen Instruments zu ermöglichen, da das Volumen relativ klein ist, in dem eine solche Feldüberhöhung auftritt.

Des Weiteren sind aus der Literatur (Dobatin J.F. et al., "Interventional Magnetic Resonance Imaging", Springer, 1998, Kapitel 6 und 7, S. 51-63) verschiedene Methoden zur Lokalisierung und/oder Visualisierung eines Katheters während einer MR-Untersuchung bekannt. Bei einer ersten Methode werden punkt- oder ringförmige Markierungen aus einem paramagnetischen Material als passive Magnetvorrichtungen an der Spitze eines Katheters oder Führungsdrahtes angebracht, so dass sie in MR-Datensätzen erkennbar werden. Bei einer zweiten Methode wird ein Katheter in Längsrichtung von einer Drahtschleife aus einem nichtmagnetischen Metall umgeben, wobei ein Stromfluss durch die Schleife gezielt an- und ausgeschaltet werden kann und sich das durch die Schleife erzeugte Magnetfeld in den MR-Datensätzen niederschlägt. Durch die Subtraktion von MR-Datensätzen mit und ohne Stromfluss durch die Schleife kann der Verlauf des Katheters sichtbar gemacht werden.

Die US 5 938 601 offenbart einen Katheter, dessen Außenhülle mit einer Matrix elektrischer Leiter bedeckt ist. Durch eine gezielte Beaufschlagung der Leiter mit Strom kann die magnetische Suszeptibilität des Katheters so eingestellt werden, dass sie sich der Katheterumgebung angleicht und hierdurch Störungen der Umgebung in MR-Datensätzen verhindert werden.

Aus der WO 99/18852 ist ein Katheter bekannt, an dessen Spitze eine oder mehrere Spulen angebracht sind. Durch Beaufschlagung der Spulen mit einem Strom kann in einem äußeren Magnetfeld eine Kraft auf die Katheterspitze ausgeübt werden, um diese in gewünschte Richtungen zu lenken.

Der vorliegenden Erfindung liegt deshalb die Aufgabe zugrunde, eine eingangs genannte MR-Anordnung und ein eingangs genanntes MR-Verfahren kostengünstiger und zuverlässiger auszugestalten.

Diese Aufgabe wird durch eine MR-Anordnung gemäß Anspruch 1 gelöst.

Der Erfindung liegt dabei die Erkenntnis zugrunde, dass es sehr vorteilhaft ist, wenn der Effekt, der bei der bekannten Anordnung mit der Mikrospule in einem MR-Datensatz erzielt wird, gezielt steuerbar ist, beispielsweise an- und abschaltbar ist. Bei der bekannten Anordnung ist dies nicht möglich, da die Mikrospule keine Anschlußleitung nach außen besitzt. Zwar sind auch MR-Anordnungen bekannt, bei denen eine solche Mikrospule eine Hochfrequenzleitung zu einem Empfänger aufweist, über die Hochfrequenzsignale übertragen werden können. Diese erweisen sich jedoch insoweit als sehr nachteilig, als es entlang dieser Hochfrequenzleitungen zu Feldüberhöhungen und damit zu sogenannten "hot spots" kommen kann, die modellmäßig nicht zu beschreiben und für einen Patienten somit ein nicht zu vernachlässigendes Risiko darstellen. Außerdem sind solche Lösungen verhältnismäßig teuer.

Erfindungsgemäß wird deshalb an dem Katheters ein passives Maguet (3) bzw. ein MR-kontrastmittel (im folgenden Maguet vorrichtung genannt) vorgesehen, welcher/welches sich von außen steuern läßt, ohne dass eine Hochfrequenzleitung nach außen geführt ist. Bei dieser Magnetvorrichtung läßt sich steuern, ob und mit welcher Stärke eine Information über die Position der Magnetvorrichtung in einem MR-Datensatz, beispielsweise in einer Projektion oder einem Schichtbild durch die Magnetvorrichtung enthalten ist. So ist es beispielsweise möglich, die Magnetvorrichtung derart zu steuern, dass die Information über die Position der Magnetvorrichtung in einem ersten MR-Datensatz enthalten und die Magnetvorrichtung somit deutlich in einem ersten MR-Bild zu sehen ist, während in einem zweiten, gleich anschließend ermittelten MR-Datensatz derselben Anatomie keine Information über die Position der Magnetvorrichtung enthalten ist, so dass die Magnetvorrichtung in einem aus dem zweiten MR-Datensatz erstellten MR-Bild auch nicht sichtbar ist. Aus der gemäß der Erfindung ist vorgesehen, dass die Lage und/oder die Position der Magnetvorrichtung relativ zu dem medizinischen Instrument mittels der Steuereinheit veränderbar ist. Dadurch ist es beispielsweise möglich, nacheinander zwei MR-Datensätze derselben Anatomie zu ermitteln, wobei sich nur die Lage und/oder die Position der Magnetvorrichtung verändert hat, nicht aber die Position des medizinischen Instruments. Aus der Differenz der beiden MR-Datensätze kann wiederum ein dritter MR-Datensatz ermittelt werden, der keine Informationen über die Anatomie, sondern nur Informationen über die Magnetvorrichtung enthält.

Vorteilhafterweise sind die Steuerbefehle für die Steuereinheit in die MR-Sequenzen zur Steuerung der MR-Anordnung und zur Ermittlung der MR-Datensätze integriert, so dass die Steuerung der Magnetvorrichtung automatisch während der Erfassung der MR-Datensätze erfolgt. Es ist somit nicht erforderlich, dass der Benutzer besondere Handlungen oder Eingaben vornimmt, um eine Positionsbestimmung des medizinischen Instruments zu veranlassen. Bei der bekannten MR-Anordnung müßte dagegen der Benutzer, um zwei MR-Datensätze zu erhalten, aus denen sich die Position der Mikrospule ermitteln ließe, die Position des medizinischen Instruments samt Mikrospule von Hand verändern, also aktiv eine Handlung vornehmen. Die Steuerung der Magnervorrichtung und die darauf abgestimmte Ermittlung der MR-Datensätze erfolgen gemäß der Erfindung automatisch und programmgesteuert.

Die Erfindung bietet somit eine Lösung, um mit verhältnismäßig einfachen und kostengünstigen Mitteln bei hoher Zuverlässigkeit die Position eines medizinischen Instruments in einem Untersuchungsobjekt bestimmen und in einem MR-Bild visualisieren zu können.

Die Erfindung wird nachfolgend anhand der Zeichnungen näher erläutert. Es zeigen:
- Fig. 1: ein Prinzipschaltbild einer ersten Ausführungsform der Erfindung,
- Fig. 2: eine erfindungsgemäß ausgestaltete MR-Sequenz und

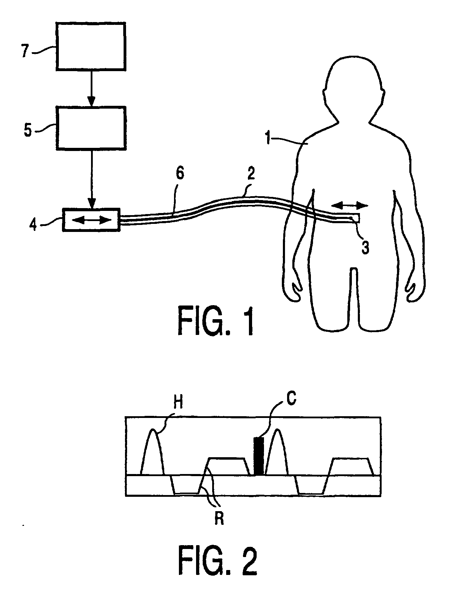

Bei der in Fig. 1 gezeigten ersten Ausführungsform der Erfindung ist in den Körper eines Patienten 1 ein Katheter eingebracht, in dessen Lumen eine flexible Welle 6 eingeführt ist. An der Spitze dieser Welle ist eine passive Magnetvorrichtung 3, beispielsweise ein kleines ferrimagnetisches Partikel 3 (z.B. aus Dysprosium), ein sehr kleines ferromagnetisches Partikel oder eine kleine Menge MR-Kontrastmittel, angebracht, dessen Position oder Orientierung innerhalb des Katheters 2 von außen variiert werden kann, ohne dass sich der Katheter 2 relativ zum Körper des Patienten 1 bewegen muß. Dazu ist die Welle 6 im Lumen des Katheters 2 frei drehbar sowie vorschiebbar und zurückziehbar. Das körperferne Ende der Welle 6 ragt aus dem körperfernen Ende des Katheters 2 heraus, wo sich ein Stellglied 4 befindet, das die Welle 6 innerhalb des Katheters 2 vor- und zurückziehen oder drehen kann. Das Stellglied 4 ist beispielsweise ein Elektromagnet, ein Elektromotor oder ein anderweitig extern steuerbares Stellelement, das von einer separaten Steuereinheit 5 gesteuert wird, die wiederum Steuerbefehle von der die gesamte MR-Anordnung steuernden MR-Steuer- und Recheneinheit 7 erhält.

Zur Steuerung des Stellgliedes 4 enthalten die MR-Sequenzen (siehe Fig. 2) neben den üblichen Befehlen für die HF-Spulen (Anregungsimpuls H) und die Gradientenspulen (z.B. Lesegradienten R) auch Steuerbefehle C für das Stellglied 4. Diese Steuerbefehle C werden dazu benutzt, während der Erfassung der MR-Datensätze die Position oder Orientierung des Partikels 3 zu variieren und mindestens zwei MR-Datensätze zu erzeugen, die entsprechende Suszeptibilitätsartefakte an unterschiedlichen Stellen oder unterschiedlicher Erscheinung enthalten. Eine entsprechende Datenverarbeitung dieser MR-Datensätte, beispielsweise eine Subtraktion beider MR-Datensätze, extrahiert schließlich die Position des Partikels 3 und damit die Position des Katheters 1. Die MR-Datensätze können dabei entweder vollständige MR-Bilder sein oder auch nur wenige Projektionsmessungen auf unterschiedlichen Raumachsen. Diese Datenverarbeitung kann dabei direkt in der MR-Steuer- und Recheneinheit 7 erfolgen, so dass die Position des Katheters 2 nicht nur dem Benutzer mitgeteilt wird, sondern auch der MR-Anordnung für andere Zwecke zur Verfügung steht, beispielsweise um den von dem Katheter zurückgelegten Weg zu verfolgen oder immer ein MR-Bild in einer Schicht senkrecht zur Katheterbewegungsrichtung und durch die Katheterspitze zu erfassen.

Die erfindungsgemäßen Maßnahmen erfordern keine besondere Bauform oder Veränderung des Katheters 2, sondern können mit einfachen Mitteln hinzugefügt werden. Die MR-Steuer- und Recheneinheit 7 muß lediglich in der Lage sein, die in der MR-Sequenz eingesetzten Steuerbefehle C in entsprechende Steuersignale für die Steuereinheit 5 oder auch direkt für das Stellglied 4 umzusetzen, was bei vielen MR-Anordnungen in der Praxis bereits für andere Zwecke vorgesehen ist.

Statt eines einzigen an der Spitze der Welle 6 angeordneten Partikels 3 als Magnetvorrichtung können auch mehrere solcher Partikel in festen Abständen an der Welle 6 angebracht sein. Die Partikel sollten aus einem Material bestehen, die die Partikel in einem MR-Bild oder einem MR-Datensatz sichtbar machen bzw. deutlich von der Anatomie unterscheiden lassen.

Die Welle 6 samt Partikel 3 und Stellglied 4 kann von dem Katheter 6 entfernt werden, falls das Lumen des Katheters 2 anderweitig benötigt wird; sie können auch jederzeit wieder angebracht werden, um den Katheter 2 wieder zu lokalisieren. Beides kann geschehen, während der Katheter 2 sich im Körper des Patienten 1 befindet.

## Patentansprüche

1. MR Anordnung mit Mitteln zur Lokalisierung und/oder Visualisierung eines in ein Untersuchungsobjekt (1) einführbaren Katheters (2), enthaltend
a) eine MR Steuer- und Recheneinheit (7);
b) den Katheter (2), in dessen Lumen eine flexible Welle (6) eingeführt ist;
c) ein passiver Maguet (3) oder ein MR-Kontrastmittel, welcher/welches mittels der Welle (6) im Lumen des Katheters (2) frei drehbar sowie vorschiebbar und zurückziehbar ist;
d) eine Steuereinheit (4, 5) zur Bewegung der Welle (6) in Abhängigkeit von von der MR-Steuer- und Recheneinheit (7) übermittelten Signalen.

2. MR Anordnung nach Anspruch 1,
**dadurch gekennzeichnet, dass** die MR Steuer- und Recheneinheit (7) so eingerichtet ist, dass die Steuerung der Welle (6) automatisch während der Erfassung der MR-Datensätze erfolgt.

3. MR Anordnung nach Anspruch 1,
**dadurch gekennzeichnet,**
**dass** die MR-Steuereinheit (7) zur Erfassung von MR-Datensätzen ausgestaltet ist, derart, dass ein erster MR-Datensatz in einer ersten Steuerstellung des passiven Magueten (3) bzw. des MR-Kontrastmittels und ein zweiter MR-Datensatz in einer zweiten Steuerstetlung des passiven Magueten (3) bzw. des MR-Kontrastmittels (3) erfaßt werden und dass anschließend aus der Differenz der beiden MR-Datensätze die Position des Katheters (2) ermittelt wird.

## Claims

1. An MR device with means for localizing and/or visualizing a catheter (2) that can be inserted into an object to be examined (1), the device comprising
a) an MR control and arithmetic unit (7);
b) the catheter (2) in whose lumen a flexible spindle (6) is inserted;
c) a passive magnet (3) or an MR contrast medium, which magnet or medium can be rotated freely and moved to and fro by means of the spindle (6) in the lumen of the catheter (2)
d) a control unit (4, 5) for moving the spindle (6) in dependence on signals transmitted from the MR control and arithmetic unit (7).

2. An MR device as claimed in claim 1, **characterized in that** the MR control and arithmetic unit (7) is arranged such that the spindle (6) automatically follows the control during the acquisition of the MR data sets.

3. An MR device as claimed in claim 1, **characterized in that** the MR control unit (7) is arranged for acquiring MR data sets so that a first MR data set is acquired in a first control position of the passive magnet (3) or of the MR contrast medium respectively, and a second MR data set is acquired in a second control position of the passive magnet (3) or of the MR contrast medium respectively, and **in that** subsequently the position of the catheter(2) is determined from the difference between the two MR data sets.

## Revendications

1. Dispositif RM avec des moyens pour la localisation et/ou la visualisation d'un cathéter à introduire dans un objet d'examen (1), contenant :
a) une unité de commande et de calcul RM (7);
b) le cathéter (2) dans la lumière duquel un axe flexible (6) a été introduit;
c) un aimant (3) passif ou un produit de contraste RM qui peut être avancé et reculé librement à rotation à l'aide de l'axe (6) dans la lumière du cathéter (2);
d) une unité de commande (4, 5) pour le déplacement de l'axe (6) en fonction des signaux transmis par l'unité de commande et de calcul RM (7).

2. Dispositif RM selon la revendication 1,
**caractérisé en ce que** l'unité de commande et de calcul RM (7) est conçue de telle sorte que la commande de l'axe (6) se produise automatiquement pendant la saisie des jeux de données RM.

3. Dispositif RM selon la revendication 1,
**caractérisé en ce**
**que** l'unité de commande RM (7) pour la saisie de jeux de données RM est conçue de telle sorte qu'un premier jeu de données RM soit saisi dans une première position de commande de l'aimant passif (3) ou du produit de contraste RM et un deuxième jeu de données RM dans une deuxième position de commande de l'aimant passif (3) ou du produit de contraste RM (3) et qu'ensuite, la position du cathéter (2) est déterminée à partir de la différence des deux jeux de données RM.
